# EUROPEAN PATENT SPECIFICATION

(11) **EP 3 406 402 B1**
(45) Date of publication and mention of the grant of the patent: **30.06.2021**
(21) Application number: 18181304.9
(22) Date of filing: 05.08.2011
(51) Int. Cl.: B24B 37/32, B24B 41/06

(54) **SUBSTRATE EDGE TUNING WITH RETAINING RING**
SUBSTRATKANTENBEARBEITUNG MIT EINEM HALTERING
RÉGLAGE DE BORD DE SUBSTRAT COMPORTANT UNE BAGUE DE RETENUE

(30) Priority: 06.08.2010 US 201061371644 P; 26.04.2011 US 201161479271 P
(43) Date of publication of application: 28.11.2018
(62) Divisional of application: 11815393.1
(73) Proprietor: Applied Materials, Inc., Santa Clara, CA 95054 (US)
(72) Inventor: CHEN, Hung Chih, Sunnyvale, CA California 94085 (US); HSU, Samuel Chu-Chiang, Palo Alto, CA California 84303 (US); YUAN, Yin, Santa Clara, CA California 95051 (US); ZHANG, Huanbo, San Jose, CA California 95124 (US); DANDAVATE, Gautam Shashank, Sunnyvale, CA California 94085 (US); SILVETTI, Mario David, Morgan Hill, CA California 95037 (US)
(74) Representative: Fish & Richardson P.C.

(56) References cited:
- EP-A1- 0 992 322
- EP-A2- 1 038 636
- WO-A1-2005/113193
- DE-U1- 20 309 051
- US-A1- 2007 034 335
- US-A1- 2008 119 120
- US-B1- 6 334 810

## Description

### TECHNICAL FIELD

This invention relates to a carrier head for use in chemical mechanical polishing.

### BACKGROUND

An integrated circuit is typically formed on a substrate by the sequential deposition of conductive, semiconductive or insulative layers on a silicon substrate. One fabrication step involves depositing a filler layer over a non-planar surface, and planarizing the filler layer until the non-planar surface is exposed. For example, a conductive filler layer can be deposited on a patterned insulative layer to fill the trenches or holes in the insulative layer. The filler layer is then polished until the raised pattern of the insulative layer is exposed. After planarization, the portions of the conductive layer remaining between the raised pattern of the insulative layer form vias, plugs and lines that provide conductive paths between thin film circuits on the substrate. For other applications, such as oxide polishing, the filler layer is planarized until a predetermined thickness is left over the non planar surface. In addition, planarization is needed to planarize the substrate surface for photolithography.

Chemical mechanical polishing (CMP) is one accepted method of planarization. This planarization method typically requires that the substrate be mounted on a carrier head. The exposed surface of the substrate is typically placed against a rotating polishing pad. The carrier head provides a controllable load on the substrate to push it against the polishing pad. A polishing liquid, such as a slurry with abrasive particles, is typically supplied to the surface of the polishing pad.

The carrier head provides a controllable load on the substrate to push it against the polishing pad. The carrier head has an inner ring which holds the substrate in place during polishing. The carrier head can also have an outer ring which surrounds the inner ring.

US 2008/0119120 describes a carrier head that has a housing, a base assembly, a retaining ring, a carrier/outer ring, and a flexible membrane. The base assembly is vertically movable relative to the housing. The retaining ring is connected to and vertically movable relative to the base assembly and has a lower surface configured to contact a polishing pad and an inner surface configured to circumferentially surround the edge of a substrate to retain the substrate. The carrier/outer ring is connected to and vertically fixed relative to the base assembly, circumferentially surrounds the retaining ring to prevent lateral motion of the retaining ring, and has a bottom surface configured to contact a polishing pad. The carrier/outer ring of the embodiment depicted in figure 4E in US 2008/119120 A1, represents the subject-matter closest to the claimed invention. It comprises an annular body having an inner surface, an annular lower surface configured to be brought into contact with a polishing pad, an annular upper surface, and an outer surface, herein the inner surface includes a region configured to circumferentially surround the inner ring that is sloped such that an inner radial diameter of the upper region is greater at a top of the upper region than at a bottom of the upper region, and wherein the outer surface includes a lower region adjacent to the lower surface that is a vertical cylindrical surface, an upper region that is a vertical cylindrical surface and has a greater outer radial diameter than the lower region of the outer surface, a horizontal lower surface extending inwardly from the vertical cylindrical surface of the upper region, and a sloped area connecting the lower portion of the outer surface to the horizontal lower surface.

EP 0992322 describes a polishing apparatus for polishing a workpiece such as a semiconductor wafer to a flat mirror finish.

US 6,293,858 describes a polishing apparatus for polishing a workpiece such as a semiconductor wafer to a flat mirror finish includes a turntable with a polishing cloth mounted on an upper surface thereof and a top ring for polishing a semiconductor wafer to a flat mirror finish by placing the semiconductor wafer between the turntable and the top ring and pressing the semiconductor wafer under a certain pressing force. A presser ring is vertically movably provided around the top ring. A pressing device presses the presser ring against the polishing cloth under a variable pressing force, and the presser ring is supported by the top ring through a bearing.

### SUMMARY

The "edge exclusion region" is an annular region at the edge of the substrate where the polishing rate may deviate significantly from the polishing rate near the center of the substrate, rendering this region unsuitable or providing lower yield for devices. For example, for some carrier heads designed for polishing of a 300 mm wafer, the edge exclusion region can be about 15 mm wide.

A variety of techniques can be used to compensate for edge exclusion. For carrier heads that have both an inner ring and an outer ring, by making the inner ring relatively narrow, the outer ring can be moved sufficiently close to the edge of the substrate that both the inner ring and the outer ring may be used to control pressure near the edge of the substrate. For a carrier head with a retaining ring with an adjustable diameter, the diameter can be selected to provide a lateral spacing between the retaining ring and the substrate that improves polishing uniformity in the exclusion region. Also, some ring geometries can shift the pad contact away from the substrate edge.

The present invention is defined by the appended claims.

The embodiments of the invention may include one or more of the following advantages. Both the inner ring and the outer ring may be used to control pressure near the edge of the substrate. This provides an additional controllable parameter for tuning of the pressure applied to the edge of the substrate. Consequently, polishing uniformity near the substrate edge may be improved, edge exclusion may be reduced, and yield may be increased.

The details of one or more embodiments of the present invention are set forth in the accompanying drawings and the description below. Other aspects, features and advantages will be apparent from the description and drawings, and from the claims.

### DESCRIPTION OF DRAWINGS

FIG. 1 shows a schematic cross-sectional view of a carrier head.
FIG. 2 shows an expanded side view, partially in perspective and partially cross-sectional, of a carrier head.
FIG. 3 is a cross-sectional side view of an inner ring.
FIG. 4 is a cross-sectional side view of a membrane.
FIG. 5. is a cross-sectional side view of an outer ring.
FIG. 6 is a bottom view of a carrier head.
FIG. 7 shows a schematic cross-sectional side view of an inner ring, an outer ring and a substrate.
FIG. 8 shows a schematic cross-sectional side view of three rings and a substrate.
FIG. 9A and 9B show schematic cross-sectional side views of a retaining ring and substrate.
FIG. 10 shows a schematic cross-sectional side view of a retaining ring and a substrate.

Like reference symbols in the various drawings indicate like elements.

### DETAILED DESCRIPTION

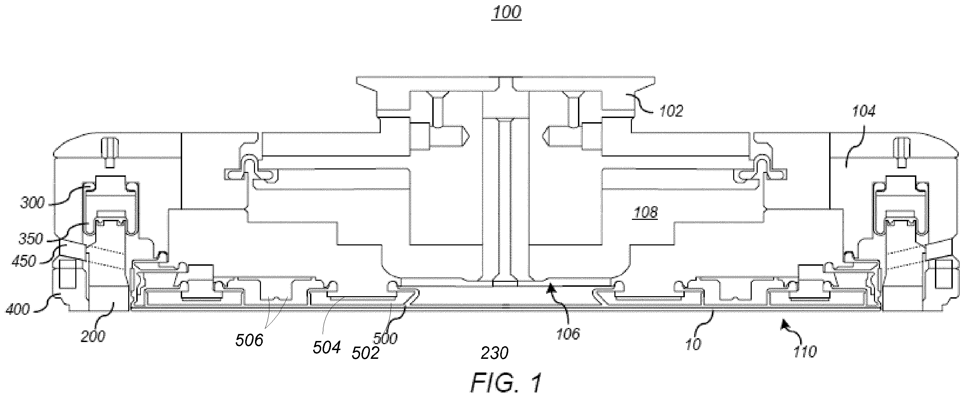

Referring to FIG. 1, a substrate 10 will be polished by a chemical mechanical polishing (CMP) apparatus that has a carrier head 100. A description of a CMP apparatus may be found in U.S. Patent No. 5,738,574.

The carrier head 100 includes a housing 102, a base assembly 104, a gimbal mechanism 106 (which may be considered part of the base assembly 104), a loading chamber 108, an inner ring assembly including an inner ring 200 (which can also be called a retaining ring) and a first flexible membrane 300 shaped to provide an annular chamber 350, an outer ring 400, and a substrate backing assembly 110 which includes a second flexible membrane 500 that defines a plurality of pressurizable chambers.

The housing 102 can generally be circular in shape and can be connected to a drive shaft to rotate therewith during polishing. There may be passages (not illustrated) extending through the housing 102 for pneumatic control of the carrier head 100. The base assembly 104 is a vertically movable assembly located beneath the housing 102. The gimbal mechanism 106 permits the base assembly 104 to gimbal relative to the housing 102 while preventing lateral motion of the base assembly 104 relative to the housing 102. The loading chamber 108 is located between the housing 102 and the base assembly 104 to apply a load, i.e., a downward pressure or weight, to the base assembly 104. The vertical position of the base assembly 104 relative to a polishing pad is also controlled by the loading chamber 108. The substrate backing assembly 110 includes a flexible membrane 500 with a lower surface 512 that can provide a mounting surface for a substrate 10.

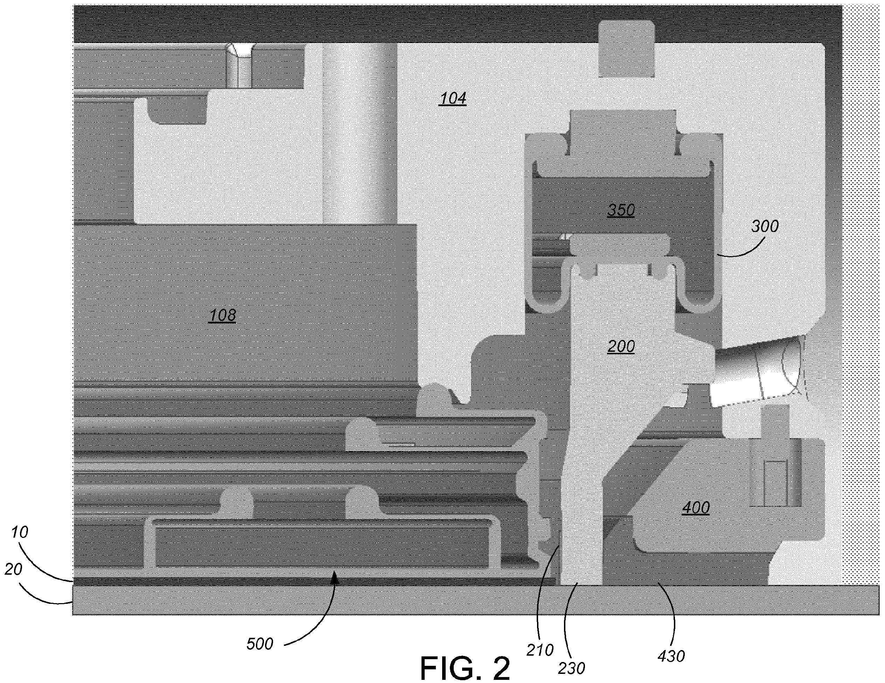

Referring to FIGS. 2, a substrate 10 can be held by an inner ring assembly clamped to a base assembly 104. The inner ring assembly can be constructed from an inner ring 200 and a flexible membrane 300 shaped to provide an annular chamber 350. The inner ring 200 can be positioned beneath the flexible membrane 300 and configured to be secured to the flexible membrane 300.

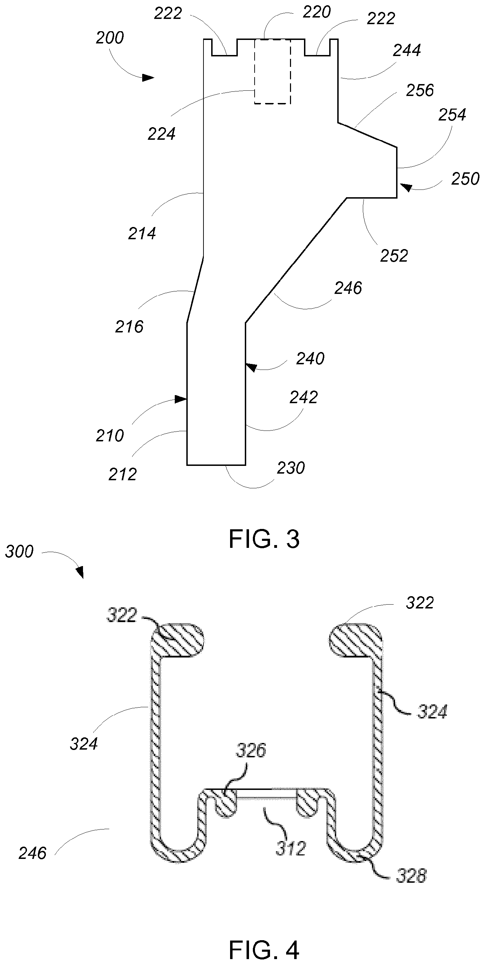

Referring to FIGS. 2 and 3, the inner ring 200 is an annular body that has an inner surface 210, an annular upper surface 220, an annular lower surface 230, and an outer surface 240. A lower region 212 of the inner surface 210, adjacent to the lower surface 230, can be a vertical cylindrical surface, and can be configured to circumferentially surround the edge of a substrate 10 to retain the substrate during polishing. The lower region 212 of the inner surface 210 can have an inner diameter just larger than the substrate diameter, e.g., about 1-2 mm larger than the substrate diameter, so as to accommodate positioning tolerances of the substrate loading system. An upper region 214 of the inner surface 210 can be a vertical cylindrical surface, and can be slightly recessed relative to the lower region 212, e.g., the inner radial diameter of the upper region 214 of the inner surface 210 is greater than the inner radial diameter of the lower region 212 of the inner surface 210. A tapered region 216 can connect the lower region 212 to the upper region 214.

A lower region 242 of the outer surface 240, adjacent to the lower surface 230, can be a vertical cylindrical surface. The portion of the inner ring between the lower region 212 and the lower region 242 can provide a lower annular ring, e.g., with a width of 0.10 and 0.51 cm (0.04 to 0.20 inches), e.g., 0.13 and 0.38 cm (0.05 to 0.15 inches). An upper region 244 of the outer surface 240, adjacent to the upper surface 220, can be a vertical cylindrical surface, and the lower region 242 of the outer surface 240 can be recessed relative to the upper region 244, e.g., the outer radial diameter of the upper region 244 is greater than the outer radial diameter of the lower region 242 of the outer surface 240. The portion of the inner ring between the upper region 214 and the upper region 244 can provide an upper annular ring that is wider than the lower annular ring. The outer radial diameter of the lower ring (i.e., the lower region 242 of the outer surface 240) can be greater than the inner radial diameter of the upper ring (i.e., the upper region 214 of the inner surface 210).

The outer surface 240 of the inner ring 200 can project outwardly to form a lip 250 between the lower region 242 and the upper region 244. The lip 250 can have a horizontal lower surface 252, a vertical outer surface 254, and a sloping, non-horizontal upper surface 256. The lip 250 can provide a hard stop for the inner ring against the top inner edge of the outer ring 400 as the inner ring wears during substrate polishing. A recess 244 above the lip 250 provides space for the side walls 324 of the flexible membrane 300 to roll when the chamber 350 is evacuated. A sloped area 246 of the outer surface 240 can connect the lower region 242 to the horizontal lower surface 252 of the lip 250.

The annular upper surface 220 can have two annular concentric recesses 222 that extend entirely around the annular inner ring 200. These annular concentric recesses 222 can be sized to interlock with the flexible membrane 300.

The lower surface 230 of the inner ring 200 can be brought into contact with a polishing pad. At least a lower portion of the inner ring 200 that includes the lower surface 230 can be formed of a material which is chemically inert in a CMP process, such as a plastic, e.g., polyphenylene sulfide (PPS). The lower portion should also be durable and have a low wear rate. In addition, the lower portion should be sufficiently compressible so that contact of the substrate edge against the inner ring does not cause the substrate to chip or crack. On the other hand, the lower portion should not be so elastic that downward pressure on the inner ring causes the lower portion to extrude into the substrate receiving recess.

In some implementations, the inner ring 200 can be constructed from two rings, a lower annular portion and an upper annular portion. The upper portion of the inner ring 200 can be formed of a material that is more rigid than the lower portion. For example, the lower portion can be a plastic, e.g., PPS, and the upper portion can be a metal, e.g., stainless steel, molybdenum, or aluminum, or a ceramic, e.g., alumina.

The upper surface 220 can include cylindrical recesses or holes 224 with screw sheaths (not shown) to receive fasteners, such as bolts, screws, or other hardware, for securing the inner ring 200 to the flexible membrane 300 positioned above it. The holes 224 can be evenly spaced around the inner ring and can be positioned between the two annular concentric recesses 222.

In some implementations, the inner ring 200 has one or more slurry transport channels formed in the lower surface 230. The slurry transport channels extend from the inner diameter to the outer diameter of the lower ring portion to allow slurry to pass from the exterior to the interior of the inner ring during polishing. The slurry transport channels can be evenly spaced around the inner ring. Each slurry transport channel can be offset at an angle, e.g., 45°, relative to the radius passing through the channel. The channels can have a width of about 0.318 cm (0.125 inches).

In some implementations, the inner ring 200 has one or more through holes that extend through the body of the inner ring from the inner surface 210 to the outer surface 240 for allowing fluid, e.g., air or water, to pass from the interior to the exterior, or from the exterior to the interior, of the inner ring during polishing. The through-holes can extend through the upper ring. The through holes can be evenly spaced around the inner ring.

In some implementations the upper portion 244 of the inner ring can be wider at its lower surface than its upper surface. For example, the inner surface 210 can have a tapered region 216 sloped inwardly (i.e., having decreasing diameter) from top to bottom below the vertical region 214. The inner surface of the lower portion 212 can be vertical. As the lower portion of the inner ring wears during substrate polishing, the narrower upper inner surface of the inner ring prevents wear on an adjacent flexible membrane that provides a substrate-mounting surface. In addition, in some implementations, the entire outer surface of the inner ring can be coated with a non-stick coating, e.g., parylene.

The inner ring 200 and a flexible membrane 300 together form the inner ring assembly. The flexible membrane 300 is configured to be clamped above to a base assembly 104 and secured below to an annular inner ring 200, providing an annular chamber 350 above the inner ring. When the annular chamber 350 is pressurized, the flexible membrane provides an independently controllable load on the inner ring. The load on the inner ring provides a load to a polishing pad. Independent loading on the inner ring can allow consistent loading on the pad as the ring wears. Positioning the flexible membrane between the inner ring and the carrier head can reduce or eliminate the impact of carrier distortion on the inner ring which occurs when the ring is directly secured to the carrier head. The elimination of this carrier distortion reduces the uneven wear on the inner ring, reduces process variability at the substrate edge, and enables lower polishing pressures to be used, increasing ring lifetime.

As shown in FIG. 4, the flexible membrane 300 has concentric inner and outer side walls 324. The flexible membrane 300 can have a pair of annular rims 322 extending horizontally and inwardly from the top edge of the side walls 324. The flexible membrane can be clamped to a base assembly 104 with a clamp ring positioned below the annular rims 322 of the flexible membrane. Additionally, the flexible membrane 300 has a lower surface. There can be two annular concentric projections 326 extending downwardly from the annular lower surface of the flexible membrane. These annular concentric projections 326 can be sized to fit into the annular concentric recesses 222 in the top surface 220 of the inner ring 200 positioned below the flexible membrane 300.

The flexible membrane 300 of the inner ring assembly can be formed of a material that is elastic, allowing the membrane to flex under pressure. The elastic material can include silicone and other exemplary materials.

The lower surface of the flexible membrane can include circular holes 312. The circular holes 312 can be positioned between the two annular concentric projections 326 and can be evenly spaced around the lower surface of the flexible membrane. The circular holes 312 can accommodate fasteners, such as bolts, screws, or other hardware, for securing the flexible membrane 300 to the inner ring 200. In some implementations, to secure the flexible membrane 300 to the inner ring 200, an adhesive, e.g., Loctite (Trademark), is placed in the holes 224, and one-way screws are inserted through the holes 312 in the flexible membrane 300 into the receiving holes 224. Thus, the flexible membrane 300 can be effectively permanently joined to the inner ring 200.

In some implementations, the concentric inner and outer side walls 324 of the flexible membrane 300 can wrap around below to form a lower surface with curved portions 328. When the flexible membrane is secured to an inner ring 200, the curved portions 328 can extend below the upper surface of the inner ring. The curved portions 328 provide a rolling hinge that permits the bottom of the flexible membrane to move up and down in response to pressurization or evacuation of the chamber 350 without substantial bulging of the side walls 324 . In some embodiments, the annular rims 322 can be thicker than the side walls 324 of the flexible membrane. The annular concentric projections 326 can also be thicker than the side walls 324.

While the inner ring 200 is configured to retain a substrate 10 and provide active edge process control, the outer ring 400 provides positioning or referencing of the carrier head to the surface of the polishing pad. In addition, the outer ring 400 contacts and provides lateral referencing of the inner ring 200. The outer ring 400 is configured to circumferentially surround an inner ring 200. Like the inner ring, the lower surface 430 of the outer ring 400 can be brought into contact with a polishing pad. The lower surface 430 of the outer ring 400 can be smooth and wearable surface; the lower surface 430 is not configured to abrade the polishing pad.

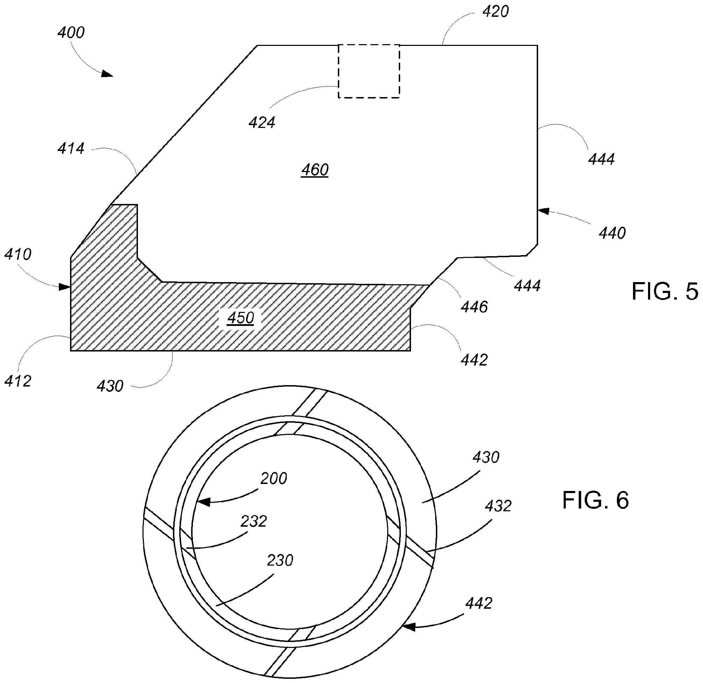

As shown in FIG. 5, the outer ring 400 is an annular body that has an inner surface 410, an annular upper surface 420, an annular lower surface 430, and an outer surface 440. A lower region 412 of the inner surface 410, adjacent to the lower surface 430, can be a vertical cylindrical surface, and can be configured to circumferentially surround the lower portion 242 of the outer surface 240 of the inner ring 200. An upper region 414 of the inner surface 410 can be a sloped, and can have the same inclination as the sloped area 246 of the inner ring 200. The upper region 414 is sloped downwardly and radially inwardly, i.e., such that the inner radial diameter of the upper region 414 of the inner surface 410 is greater at the top of the upper region 414 than the bottom. The sloped area 246 of the inner ring 200 can extend vertically over the sloped upper region 414 of the outer ring 400.

A lower region 442 of the outer surface 440 of the outer ring 400, adjacent to the lower surface 430, can be a vertical cylindrical surface. An upper region 444 of the outer surface 440, adjacent to the upper surface 420, can be a vertical cylindrical surface, and the lower region 442 of the outer surface 440 can be recessed relative to the upper region 444, e.g., the outer radial diameter of the upper region 444 is greater than the outer radial diameter of the lower region 442 of the outer surface 440. The outer radial diameter of the lower region 442 of the outer surface 440 can be greater than the inner radial diameter of the upper region 414 of the inner surface 410. The outer surface 440 can also include a horizontal lower surface 444 and a sloping, non-horizontal lower surface 446. The horizontal lower surface 444 can provide a hard stop for the outer ring 400 against a substrate loading station, and the sloping surface 446 can provide for self-centering of the carrier head in the substrate loading station as the carrier head is lowered into the loading station.

The upper surface 420 of the outer ring 400 can be secured to the base 104, e.g., it is not vertically movable relative to the base 104. The upper surface 420 of the outer ring 400 can include cylindrical recesses or holes 424 with screw sheaths (not shown) to receive fasteners, such as bolts, screws, or other hardware, for securing the outer ring 400 to the base assembly 104. The holes 424 can be evenly spaced around the outer ring 400. In some implementations, the holes 424 do not extend over the horizontal lower surface 444.

A width of the lower surface 430 of the outer ring 400, i.e., between the lower region 412 of the inner surface 410 and the lower region 442 of the outer surface 440, can be greater than the width of the lower surface 230 of the inner ring 200, i.e., between the lower region 212 of the inner surface 410 and the lower region 242 of the outer surface 240. For example, the width can be 0.10 and 2.5 cm (0.04 to 1.0 inches_.

In some implementations, the outer ring 400 can be constructed from two rings, a lower annular portion 450 and an upper annular portion 460. The upper portion 460 of the outer ring 400 can be formed of a material that is more rigid than the lower portion 450. For example, the lower portion 450 can be a plastic, e.g., polyetheretherketone (PEEK), carbon filled PEEK, Teflon® filled PEEK, polyamidimid (PAI), or a composite material. The upper portion 460 can be a metal, e.g., stainless steel, molybdenum, or aluminum, or a ceramic, e.g., alumina.

The portion of the outer ring 400 that includes the lower surface 430 can be formed of a more rigid material than the portion of the inner ring 200 that includes the lower surface 230. This can result in the outer ring wearing at a lower rate than the inner ring. For example, the lower portion 450 of the outer ring 400 can be a plastic that is harder than the plastic of the inner ring 200.

In some implementations, the outer ring 400 has one or more through-holes that extend from the inner surface 410 to the outer surface 430 for allowing a liquid or air to pass from the interior to the exterior, or from the exterior to the interior, of the outer ring 400 during polishing. The through-holes can be evenly spaced around the outer ring 400. In some implementations, there are through-holes in the outer ring 400 but not in the inner ring 200. Thus, fluid, e.g., water from a cleaning system, that is sprayed through the through holes in the outer ring 400 will be flushed downward along the outer surface of the inner ring 200, thus clearing the space between the outer ring 400 and inner ring 200. In other implementations, there are through-holes in both the outer ring 400 and the inner ring 200, and the through holes are aligned so that fluid will pass through both the outer ring 400 and the inner ring 200. In such implementations, the through holes through the outer ring 400 can be the same width or wider than the through holes through the inner ring 200. In some implementations (see FIG. 2), through holes 450 are formed through a portion of the base 104 that surrounds the inner ring 200, rather than through the outer ring itself.

Referring to FIG. 6, in some implementations, the outer ring 400 has one or more slurry transport channels 432 on the bottom surface 430 that extend from the inner surface 410 to the outer surface 440 to allow slurry to pass from the exterior to the interior of the outer ring during polishing. The channels can be evenly spaced around the outer ring. Each slurry transport channel can be offset at an angle, e.g., 45°, relative to the radius passing through the channel. The outer ring channels 432 can be aligned with the inner ring channels 232. In some embodiments, the outer ring channels 432 are wider than the inner ring channels 232, allowing slurry to pass more freely to the interior of the inner ring 200. For example, the outer ring channels 432 can have a width of about 0.64 cm (0.25 inches).

Returning to FIG. 1, the flexible membrane 500 provides a surface 502 to mount the substrate 10. The flexible membrane 500 includes a plurality of flaps 504, which divide the volume between the flexible membrane 500 and the base assembly 104 into a plurality of individually pressurizable chambers 506. The pressurizable chambers 506 can be formed by clamping the flaps 504 to the base assembly 104 with a plurality of concentric clamp rings. The chambers can be configured to be successively narrower, from the innermost chamber to the outermost chamber.

Each chamber in the carrier head can be fluidly coupled by passages (not shown) through the base assembly 104 and housing 102 to an associated pressure source, such as a pump or pressure or vacuum line. There can be one passage for the annular chamber 350 of the flexible membrane 300, one passage for the loading chamber 108, and one passage for each of the pressurizable chambers 506 between the base assembly 104 and the flexible membrane 500. One or more passages from the base assembly 104 can be linked to passages in the housing 102 by flexible tubing that extends inside the loading chamber 108 or outside the carrier head 100. Pressurization of each chamber, and the force applied by the associated segment of the main portion 510 of the flexible membrane 500 on the substrate 10, can be independently controlled. This permits different pressures to be applied to different radial regions of the substrate during polishing, thereby compensating for non-uniform polishing rates.

The pressure on the inner ring 200 can be varied using chamber 350 relative to and independently of the pressure in the chambers 506 defined by the membrane 500, and the pressure on the outer ring 400 can be varied using the loading chamber 108 relative to and independently of the pressures on the inner ring 200 and in the chambers 506 defined by the membrane 500.

The outer ring 400 of the carrier head can apply a downward pressure to a polishing pad. As noted above, the lower surface 230 of the inner ring 200 is relatively narrow, permitting the lower surface 430 of the outer ring 400 to be positioned sufficiently close to the edge of the substrate that the outer ring 400 may be used to control pressure on the substrate in the area near the edge of the substrate. Since both the inner ring 200 and the outer ring 400 can be used to control pressure near the edge of the substrate, the pressure from the outer ring 400 on the polishing pad provides an additional controllable parameter for tuning of the pressure applied to the edge of the substrate. Consequently, polishing uniformity near the substrate edge may be improved, edge exclusion may be reduced, and yield may be increased. In particular, a set of pressures for the inner ring 200 and outer ring 400 can be identified by experimentation. For example, multiple test substrates can be polished using different combinations of pressures for the inner ring 200 and outer ring 400 for each test substrate, but otherwise using the same process parameters for polishing of device substrates. The uniformity of the test substrates in the area near the edge can be measured, e.g., using a stand-alone metrology unit, and the combination of pressures that provided the best polishing uniformity can be selected for later polishing of device substrates.

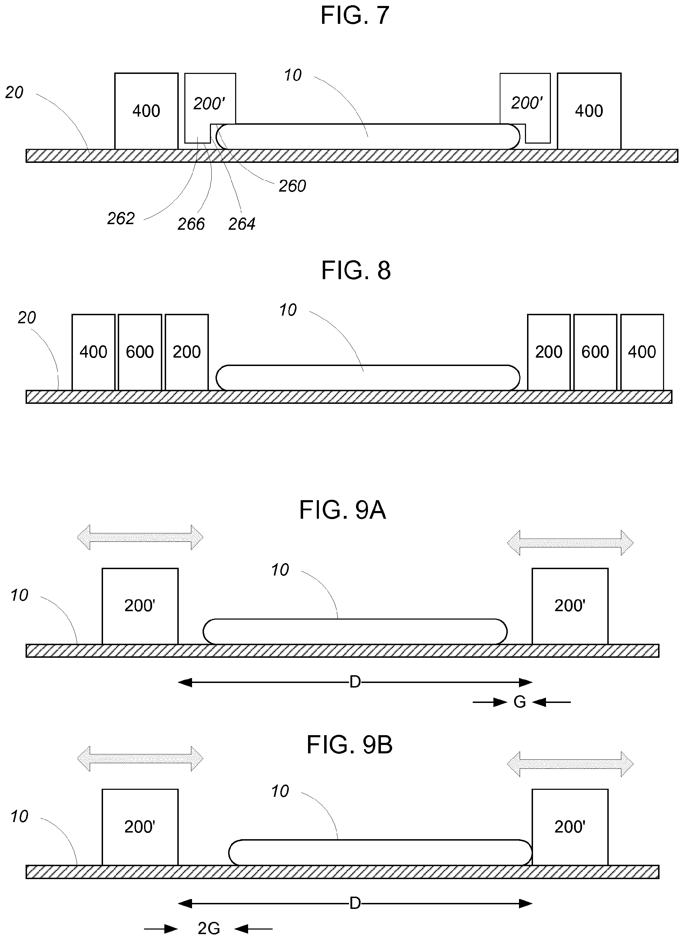

Referring to FIG. 7, in another implementation (which can otherwise be similar to the implementations discussed above), rather than be positioned to surround the substrate 10, the inner ring 200' can both rest on and circumscribe the substrate 10. In particular, bottom of the inner ring 200' can include a horizontal lower surface 260 adjacent an inner diameter of the inner ring 200', and a projection 262, positioned radially outward of the horizontal lower surface 260, that extends vertically past the horizontal surface 260. The horizontal lower surface 260 can contact the upper surface of the substrate 10 (i.e., the side of the substrate farther from the polishing pad). The inner diameter of the projection 262 provides an innerwardly facing surface 264 that retains the substrate. The height of the projection 262 can be less than the thickness of the substrate 10 such that the bottom surface 266 of the projection 262 does not contact the polishing pad 20 during polishing.

Referring to FIG. 8, in another implementation (which can otherwise be similar to the implementations discussed above), the carrier head can include three rings, including the inner ring 200, the outer ring 400, and a middle ring 600. Pressure on the middle ring 600 can be controlled in a manner similar to the retaining ring 200 with an additional chamber in the carrier head. Thus, pressure of each of the inner ring 200, outer ring 400, and middle ring 600 can be independently controllable. The additional degree of freedom provided by the middle ring 600 could permit superior polishing uniformity.

Referring to FIG. 9A, in another implementation, the carrier head can include a retaining ring 200' with an adjustable inner diameter D. Such a retaining ring is described in U.S. Patent No. 6,436,228. The carrier head can include just a single retaining ring 200' (rather than both inner and outer retaining rings). The retaining ring 200' can be set with an inner diameter D sufficiently larger than the diameter of the substrate 10 to provide a gap having a non-zero average width G (averaged around the circumference of the substrate). Of course, during polishing, friction from the polishing pad will tend to drive a leading edge of the substrate 10 against the retaining ring 200', as shown in FIG. 9B, leaving a gap of width 2G on a trailing edge of the substrate 10. However, due to relative rotational motion between the substrate 10 and the retaining ring 200', the net result on the polishing rate at the substrate edge will be an average of the different compression effects on the polishing pad.

Selection of an appropriate inner diameter D of the retaining ring 200' can improve polishing uniformity near the substrate edge, reduce edge exclusion, and increase yield. In particular, the preferred diameter D for the retaining ring 200' for a particular set of polishing parameters can be identified by experimentation. For example, multiple test substrates can be polished using different diameters D for the retaining ring 200' for each test substrate, but otherwise using the same process parameters for polishing of device substrates. The uniformity of the test substrates in the area near the edge can be measured, e.g., using a stand-alone metrology unit, and the retaining ring diameter that provides the best polishing uniformity can be selected for later polishing of device substrates As noted above, the inner diameter D can be sufficiently larger than the diameter of the substrate 10 to provide a gap having a non-zero average width G. Due to this non-zero width G of the gap, the substrate does not contact the retaining ring along a continuous circumferential zone of engagement extending around substantially the entire substrate perimeter.

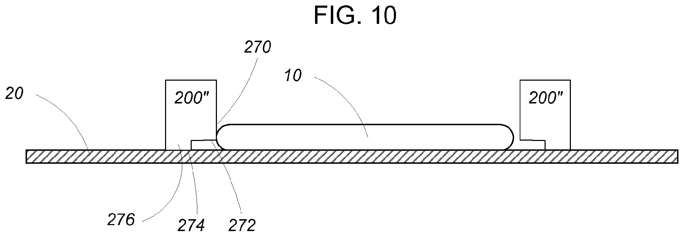

Referring to FIG. 10, in another implementation, the carrier head can include a retaining ring 200" in which the lower surface includes a step. The step can be configured such that an inner diameter 270 of the retaining ring is adjacent and retains the substrate 10 (e.g., the substrate is driven into contact with the inner diameter 270 by friction from the polishing pad during polishing). A portion 272 of the bottom of the retaining ring immediately adjacent the inner diameter 270 that contacts the substrate provides a horizontal lower surface that does not contact the polishing pad 20, whereas a portion 274 of the bottom of the retaining ring that is radially outward of the portion 272 does contact the polishing pad 20 during polishing. In particular, the bottom of the retaining ring 200" can include a horizontal lower surface 272 adjacent an inner diameter 270 of the inner ring 200', and a projection 276, positioned radially outward of the horizontal lower surface 272, that extends vertically past the horizontal surface 272. The height of the projection 276 can be less than the thickness of the substrate 10, e.g., less than half of the thickness of the substrate 10, such that the horizontal lower surface 272 is below the bevel edge of the substrate 10. By selecting an appropriate width for the horizontal lower surface 272, contact of the retaining ring 200" with the polishing pad can be moved to a position that provides improved polishing uniformity. The retaining ring 200" could be formed from a low wear material, or the portion of the retaining ring 200" above the horizontal lower surface 272 could be formed from a material that wears more quickly than the projection 276. In addition, the portion of the retaining ring 200" above the horizontal lower surface 272 could be provided with features that increase the wear rate, e.g., vertical holes that decrease the surface area of the horizontal lower surface 272.

A number of embodiments of the invention have been described. Nevertheless, it will be understood that various modifications may be made without departing from the scope of the invention as defined by the appended claims. For example, the base assembly 104 and the housing 102 could be combined as a single rigid part, and the entire carrier head 100 could be moved up and down by a vertically movable drive shaft, or a pressurizable chamber could be provided between the housing 102 and the outer ring so that inner ring and housing were both movable relative to the same rigid part. Accordingly, other implementations are within the scope of the following claims.

## Claims

1. An outer ring (400) for lateral referencing of an inner ring in a chemical mechanical polishing apparatus, the outer ring comprising:
an annular body having an inner surface (410), an annular lower surface (430) configured to be brought into contact with a polishing pad, an annular upper surface (420), and an outer surface (440),
wherein the inner surface (410) includes a lower region (412) adjacent to the lower surface that is a vertical cylindrical surface configured to circumferentially surround the inner ring and an upper region (414) extending between the lower region (412) and the upper annular surface (420), wherein the upper region (414) is sloped such that an inner radial diameter of the upper region is greater at a top of the upper region than at a bottom of the upper region, and
wherein the outer surface (440) includes a lower region (442) adjacent to the lower surface that is a vertical cylindrical surface, an upper region (444) that is a vertical cylindrical surface and has a greater outer radial diameter than the lower region (442) of the outer surface (440), a horizontal lower surface (444) extending inwardly from the vertical cylindrical surface of the upper region, and a sloped area (446) connecting the lower portion of the outer surface (440) to the horizontal lower surface.

2. The outer ring of claim 1, wherein the annular body of the outer ring comprises an upper portion between the upper region of the inner surface (410) and the upper region of the outer surface (440) and a lower portion between the lower region (412) of the inner surface (410) and the lower region (442) of the outer surface (440).

3. The outer ring of claim 2, wherein a width between the lower region (412) of the inner surface (410) of the outer ring and the lower region (442) of the outer surface (440) of the outer ring is between 0.10 and 2.5 cm (0.04 and 1.0 inches).

4. The outer ring of claim 2, wherein the upper portion of the outer ring is formed of a material that is more rigid than the lower portion.

5. The outer ring of claim 4, wherein the lower portion of the outer ring is a plastic and the upper portion of the outer ring is a metal.

6. The outer ring of claim 1, wherein the upper surface of the outer ring includes a plurality of holes to receive fasteners.

7. The outer ring of claim 6, wherein the holes are positioned such that they do not extend over the horizontal lower surface.

8. A chemical mechanical polishing apparatus comprising:
the outer ring of any one of claims 1 to 7; and
an inner ring (200) for holding a substrate, the inner ring comprising:
an annular body having an inner surface (210) configured to circumferentially surround the edge of a substrate to retain the substrate during polishing, an annular lower surface (230) configured to be brought into contact with a polishing pad, an annular upper surface (220), and an outer surface (240),
wherein the inner surface (210) includes a lower region (212) adjacent to the lower surface that is a vertical cylindrical surface and an upper region (214) that is a vertical cylindrical surface and has an inner radial diameter greater than the lower region of the inner surface, and
wherein the outer surface (240) includes a lower region (242) adjacent to the lower surface that is a vertical cylindrical surface, an upper region (244) that is a vertical cylindrical surface and has a greater outer radial diameter than the lower region of the outer surface, an outwardly projecting lip (250) between the lower region and the upper region of the outer surface, the lip including a horizontal lower surface (252), and a sloped area (246) connecting the lower portion of the outer surface to the horizontal lower surface of the lip.

9. The chemical mechanical polishing apparatus of claim 8, wherein the annular body comprises an upper portion between the upper region of the inner surface and the upper region of the outer surface and a lower portion between the lower region of the inner surface and the lower region of the outer surface.

10. The chemical mechanical polishing apparatus of claim 9, wherein the upper portion is wider than the lower portion.

11. The chemical mechanical polishing apparatus of claim 9, wherein a width between the lower region of the inner surface and the lower region of the outer surface is between 0.10 and 0.51 cm (0.04 and 0.20 inches).

12. The chemical mechanical polishing apparatus of claim 11, wherein the width is between 0.13 and 0.38 cm (0.05 and 0.15 inches).

13. The chemical mechanical polishing apparatus of claim 9, wherein the upper portion is formed of a material that is more rigid than the lower portion.

14. The chemical mechanical polishing apparatus of claim 8, wherein the inner surface includes a tapered region connecting the lower region and the upper region.

15. The chemical mechanical polishing apparatus of claim 8, wherein the upper surface includes two annular concentric recesses (222) in the annular upper surface, and a plurality of cylindrical recesses (234), each cylindrical recess positioned between the two annular concentric recesses.

## Patentansprüche

1. Außenring (400) zur seitlichen Referenzierung eines Innenrings einer chemisch-mechanischen Poliervorrichtung, wobei der Außenring umfasst:
einen ringförmigen Körper, der eine innere Oberfläche (410), eine ringförmige untere Oberfläche (430), die dafür ausgelegt ist, mit einem Polierkissen in Kontakt gebracht zu werden, eine ringförmige obere Oberfläche (420) und eine äußere Oberfläche (440) aufweist,
wobei die innere Oberfläche (410) einen unteren Bereich (412) benachbart zu der unteren Oberfläche, der eine senkrechte zylindrische Oberfläche ist, die dafür ausgelegt ist, den Innenring umfangsseitig zu umgeben, und einen oberen Bereich (414), der zwischen dem unteren Bereich (412) und der oberen ringförmigen Oberfläche (420) verläuft, aufweist, wobei der obere Bereich (414) abgeschrägt ist, so dass ein innerer radialer Durchmesser des oberen Bereichs an einer oberen Seite des oberen Bereichs größer als an einer unteren Seite des oberen Bereichs ist, und
wobei die äußere Oberfläche (440) einen unteren Bereich (442) benachbart zu der unteren Oberfläche, der eine senkrechte zylindrische Oberfläche ist, einen oberen Bereich (444), der eine senkrechte zylindrische Oberfläche ist und einen größeren äußeren radialen Durchmesser als der untere Bereich (442) der äußeren Oberfläche (440) aufweist, eine waagrechte untere Oberfläche (444), die von der senkrechten zylindrischen Oberfläche des oberen Bereichs nach innen ragt, und eine abgeschrägte Fläche (446), die den unteren Teil der äußeren Oberfläche (440) mit der waagrechten unteren Oberfläche verbindet, aufweist.

2. Außenring gemäß Anspruch 1, wobei der ringförmige Körper des Außenrings einen oberen Teil zwischen dem oberen Bereich der inneren Oberfläche (410) und dem oberen Bereich der äußeren Oberfläche (440) und einen unteren Teil zwischen dem unteren Bereich (412) der inneren Oberfläche (410) und dem unteren Bereich (442) der äußeren Oberfläche (440) umfasst.

3. Außenring gemäß Anspruch 2, wobei die Breite zwischen dem unteren Bereich (412) der inneren Oberfläche (410) des Außenrings und dem unteren Bereich (442) der äußeren Oberfläche (440) des Außenrings zwischen 0,10 und 2,5 cm (0,04 und 1,0 Inch) beträgt.

4. Außenring gemäß Anspruch 2, wobei der obere Teil des Außenrings aus einem Material gebildet ist, das steifer als der untere Teil ist.

5. Außenring gemäß Anspruch 4, wobei der untere Teil des Außenrings ein Kunststoff ist und der obere Teil des Außenrings ein Metall ist.

6. Außenring gemäß Anspruch 1, wobei die obere Oberfläche des Außenrings eine Vielzahl von Löchern zum Aufnehmen von Befestigungselementen aufweist.

7. Außenring gemäß Anspruch 6, wobei die Löcher so angeordnet sind, dass sie nicht über die waagrechte untere Oberfläche verlaufen.

8. Chemisch-mechanische Poliervorrichtung, umfassend:
den Außenring gemäß einem der Ansprüche 1 bis 7; und
einen Innenring (200) zum Halten eines Substrats, wobei der Innenring umfasst:
einen ringförmigen Körper, der eine innere Oberfläche (210), die dafür ausgelegt ist, den Rand eines Substrats umfangsseitig zu umgeben, um das Substrat während des Polierens zu halten, eine ringförmige untere Oberfläche (230), die dafür ausgelegt ist, mit einem Polierkissen in Kontakt gebracht zu werden, eine ringförmige obere Oberfläche (220) und eine äußere Oberfläche (240) aufweist,
wobei die innere Oberfläche (210) einen unteren Bereich (212) benachbart zu der unteren Oberfläche, der eine senkrechte zylindrische Oberfläche ist, und einen oberen Bereich (214), der eine senkrechte zylindrische Oberfläche ist und einen inneren radialen Durchmesser aufweist, der größer als der untere Bereich der inneren Oberfläche ist, aufweist und
wobei die äußere Oberfläche (240) einen unteren Bereich (242) benachbart zu der unteren Oberfläche, der eine senkrechte zylindrische Oberfläche ist, einen oberen Bereich (244), der eine senkrechte zylindrische Oberfläche ist und einen größeren äußeren radialen Durchmesser als der untere Bereich der äußeren Oberfläche aufweist, eine nach außen ragende Lippe (250) zwischen dem unteren Bereich und dem oberen Bereich der äußeren Oberfläche, wobei die Lippe eine waagrechte untere Oberfläche (252) aufweist, und eine abgeschrägte Fläche (246), die den unteren Teil der äußeren Oberfläche mit der waagrechten unteren Oberfläche der Lippe verbindet, aufweist.

9. Chemisch-mechanische Poliervorrichtung gemäß Anspruch 8, wobei der ringförmige Körper einen oberen Teil zwischen dem oberen Bereich der inneren Oberfläche und dem oberen Bereich der äußeren Oberfläche und einen unteren Teil zwischen dem unteren Bereich der inneren Oberfläche und dem unteren Bereich der äußeren Oberfläche umfasst.

10. Chemisch-mechanische Poliervorrichtung gemäß Anspruch 9, wobei der obere Teil breiter als der untere Teil ist.

11. Chemisch-mechanische Poliervorrichtung gemäß Anspruch 9, wobei eine Breite zwischen dem unteren Bereich der inneren Oberfläche und dem unteren Bereich der äußeren Oberfläche zwischen 0,10 und 0,51 cm (0,04 und 0,20 Inch) beträgt.

12. Chemisch-mechanische Poliervorrichtung gemäß Anspruch 11, wobei die Breite zwischen 0,13 und 0,38 cm (0,05 und 0,15 Inch) beträgt.

13. Chemisch-mechanische Poliervorrichtung gemäß Anspruch 9, wobei der obere Teil aus einem Material gebildet ist, das steifer als der untere Teil ist.

14. Chemisch-mechanische Poliervorrichtung gemäß Anspruch 8, wobei die innere Oberfläche einen abgeschrägten Bereich aufweist, der den unteren Bereich und den oberen Bereich verbindet.

15. Chemisch-mechanische Poliervorrichtung gemäß Anspruch 8, wobei die obere Oberfläche zwei ringförmige konzentrische Vertiefungen (222) in der ringförmigen oberen Oberfläche und eine Vielzahl von zylindrischen Vertiefungen (234) aufweist, wobei jede zylindrische Vertiefung zwischen den beiden ringförmigen konzentrischen Vertiefungen angeordnet ist.

## Revendications

1. Bague externe (400) pour le repérage latéral d'une bague interne dans un appareil de polissage mécanochimique, la bague externe comprenant :
un corps annulaire ayant une surface interne (410), une surface annulaire inférieure (430) configurée pour être mise en contact avec un tampon de polissage, une surface annulaire supérieure (420), et une surface externe (440),
dans laquelle la surface interne (410) comporte une région inférieure (412) adjacente à la surface inférieure qui est une surface cylindrique verticale configurée pour entourer circonférentiellement la bague interne et une région supérieure (414) s'étendant entre la région inférieure (412) et la surface annulaire supérieure (420), la région supérieure (414) étant inclinée de telle sorte qu'un diamètre radial interne de la région supérieure est plus grand à un sommet de la région supérieure qu'à une base de la région supérieure, et
dans laquelle la surface externe (440) comporte une région inférieure (442) adjacente à la surface inférieure qui est une surface cylindrique verticale, une région supérieure (444) qui est une surface cylindrique verticale et a un plus grand diamètre radial externe que la région inférieure (442) de la surface externe (440), une surface horizontale inférieure (444) s'étendant vers l'intérieur depuis la surface cylindrique verticale de la région supérieure, et une zone inclinée (446) reliant la partie inférieure de la surface externe (440) à la surface horizontale inférieure.

2. Bague externe de la revendication 1, le corps annulaire de la bague externe comprenant une partie supérieure entre la région supérieure de la surface interne (410) et la région supérieure de la surface externe (440) et une partie inférieure entre la région inférieure (412) de la surface interne (410) et la région inférieure (442) de la surface externe (440).

3. Bague externe de la revendication 2, une largeur entre la région inférieure (412) de la surface interne (410) de la bague externe et la région inférieure (442) de la surface externe (440) de la bague externe se situant entre 0,10 et 2,5 cm (0,04 et 1,0 pouce).

4. Bague externe de la revendication 2, la partie supérieure de la bague externe étant constituée d'un matériau qui est plus rigide que la partie inférieure.

5. Bague externe de la revendication 4, la partie inférieure de la bague externe étant un plastique et la partie supérieure de la bague externe étant un métal.

6. Bague externe de la revendication 1, la surface supérieure de la bague externe comportant une pluralité de trous pour recevoir des pièces de fixation.

7. Bague externe de la revendication 6, dans laquelle les trous sont positionnés de telle sorte qu'ils ne s'étendent pas au-dessus de la surface horizontale inférieure.

8. Appareil de polissage mécanochimique comprenant :
la bague externe de l'une quelconque des revendications 1 à 7 ; et
une bague interne (200) destinée à maintenir un substrat, la bague interne comprenant :
un corps annulaire ayant une surface interne (210) configurée pour entourer circonférentiellement le bord d'un substrat pour retenir le substrat pendant le polissage, une surface annulaire inférieure (230) configurée pour être mise en contact avec un tampon de polissage, une surface annulaire supérieure (220), et une surface externe (240),
dans lequel la surface interne (210) comporte une région inférieure (212) adjacente à la surface inférieure qui est une surface cylindrique verticale et une région supérieure (214) qui est une surface cylindrique verticale et a un plus grand diamètre radial interne que la région inférieure de la surface interne, et
dans lequel la surface externe (240) comporte une région inférieure (242) adjacente à la surface inférieure qui est une surface cylindrique verticale, une région supérieure (244) qui est une surface cylindrique verticale et a un plus grand diamètre radial externe que la région inférieure de la surface externe, une lèvre se projetant vers l'extérieur (250) entre la région inférieure et la région supérieure de la surface externe, la lèvre comportant une surface horizontale inférieure (252), et une zone inclinée (246) reliant la partie inférieure de la surface externe à la surface horizontale inférieure de la lèvre.

9. Appareil de polissage mécanochimique de la revendication 8, dans lequel le corps annulaire comprend une partie supérieure entre la région supérieure de la surface interne et la région supérieure de la surface externe et une partie inférieure entre la région inférieure de la surface interne et la région inférieure de la surface externe.

10. Appareil de polissage mécanochimique de la revendication 9, dans lequel la partie supérieure est plus large que la partie inférieure.

11. Appareil de polissage mécanochimique de la revendication 9, dans lequel une largeur entre la région inférieure de la surface interne et la région inférieure de la surface externe se situe entre 0,10 et 0,51 cm (0,04 et 0,20 pouce).

12. Appareil de polissage mécanochimique de la revendication 11, dans lequel la largeur se situe entre 0,13 et 0,38 cm (0,05 et 0,15 pouce).

13. Appareil de polissage mécanochimique de la revendication 9, dans lequel la partie supérieure est constituée d'un matériau qui est plus rigide que la partie inférieure.

14. Appareil de polissage mécanochimique de la revendication 8, dans lequel la surface interne comporte une région effilée reliant la région inférieure et la région supérieure.

15. Appareil de polissage mécanochimique de la revendication 8, dans lequel la surface supérieure comporte deux encoches annulaires concentriques (222) dans la surface annulaire supérieure, et une pluralité d'encoches cylindriques (234), chaque encoche cylindrique étant positionnée entre les deux encoches annulaires concentriques.
